# EUROPÄISCHE PATENTSCHRIFT

(11) **EP 3 577 252 B1**
(45) Veröffentlichungstag und Bekanntmachung des Hinweises auf die Patenterteilung: **16.08.2023**
(21) Anmeldenummer: 17829915.2
(22) Anmeldetag: 04.12.2017
(51) Int. Cl.: C23C 14/06, C23C 14/16, C23C 28/00

(54) **SCHICHTSYSTEM UND BAUTEIL**
LAYER SYSTEM AND COMPONENT
SYSTÈME STRATIFIÉ ET COMPOSANT

(30) Priorität: 02.02.2017 DE 102017102059
(43) Veröffentlichungstag der Anmeldung: 11.12.2019
(73) Patentinhaber: Schaeffler Technologies AG & Co. KG, 91074 Herzogenaurach (DE)
(72) Erfinder: SCHULZ, Edgar, 91094 Langensendelbach (DE); DOBRENIZKI, Ladislaus, 90453 Nürnberg (DE); BRUGNARA, Ricardo Henrique, 91093 Heßdorf (DE); WITTER, Oliver, 98663 Westhausen (DE)
(86) Internationale Anmeldenummer: PCT/DE2017/101041
(87) Internationale Veröffentlichungsnummer: WO 2018/141317

(56) Entgegenhaltungen:
- WO-A1-2015/186790
- CN-B- 102 181 835
- DE-A1-102014 016 983
- JP-A- 2016 183 382
- US-A- 5 593 234
- US-A- 6 114 242
- US-A1- 2004 229 457
- US-A1- 2013 029 119
- US-A1- 2016 230 274

## Beschreibung

Die Erfindung betrifft ein Schichtsystem umfassend mindestens eine Haftvermittlerschicht und mehrere, auf der mindestens einen Haftvermittlerschicht angeordnete Funktionsschichten. Die Erfindung betrifft weiterhin ein Bauteil umfassend ein metallisches Substrat und auf dem Substrat angeordnet ein derartiges Schichtsystem. Dabei soll das Schichtsystem als Verschleißschutzschicht dienen.

Schichtsysteme und Bauteile der eingangs genannten Art sind hinreichend bekannt. So offenbart die DE 10 2011 006 294 A1 ein Verfahren zur Herstellung eines beschichteten Metallbauteils. Das auf das Metallbauteil aufgebrachte Schichtsystem umfasst wenigstens eine, unter anderem metallische, Haftvermittlerschicht und eine Funktionsschicht. Die Funktionsschicht ist beispielsweise eine nitridische Hartstoffschicht oder eine Nanokompositschicht aus einem nitridischen Hartstoff und einer metallischen Komponente, die beispielsweise durch ein Element der 3. bis 5. Hauptgruppe oder der 1. bis 8. Nebengruppe des Periodensystems der chemischen Elemente gebildet ist.

Aus der WO 2012/078151 A1 sind nitridische Verschleißschutzschichten und damit beschichtete Bauteile bekannt. Die Verschleißschutzschicht weist Molybdännitrid-Körner mit einer Korngröße im Bereich von 5 bis 100 nm verteilt in einer Kupfermatrix auf, wobei die Kupfermatrix zu 0,1 bis 50 Gew.-% in der Verschleißschutzschicht vorhanden ist und die einzelnen Molybdännitrid-Körner umschließt.

Die CN 102 181 835 B beschreibt ein Werkzeug mit einer mit der Schichtenfolge auf einem Werkzuggrundmaterial aus Hartmetall oder HSS, wobei die Schichtenfolge Titan - Zirkon - Zirkonnitrid und darauf aufgebracht eine Mehrschichtstruktur aus abwechselnd Zirkon und Zirkonnitrid aufweist.

Die US 2013 / 029119 A1 offenbart einen beschichteten Gegenstand mit einer Vielzahl von Molybdännitridschichten und Titan-Aluminium-Nitrid-Schichten auf einem Substrat, wobei eine Molybdännitridschicht unmittelbar an das Substrat angrenzt.

Die US 2016 / 230274 A1 beschreibt Mehrschichtbeschichtung für eine metallische Oberfläche eines Bauteils. Die Mehrschichtbeschichtung umfasst eine erste Schicht aus Metallnitrid, eine zweite Schicht aus Metall und eine dritte Schicht aus Diamant-ähnlichem Kohlenstoff. Die Schichtfolge wiederholt sich mindestens 10 mal.

Die DE 10 2014 016 983 A1 offenbart eine Klinge mit mindestens einer Schneide, die ein Mehrschichtmaterial mit mindestens fünf Schichten aufweist. Dabei sind Metallschichten und Metallkeramikschichten abwechselnd angeordnet.

Die US 5 593 234 A beschreibt eine Lageranordnung mit einer superharten polykristallinen Übergitterbeschichtung. Die Beschichtung ist aus mindestens einem Material aus der Gruppe umfassend Metalle, Legierungen, Keramik, Nitride, Boride, Karbide, Oxide der Übergangsmetalle, Kohlenstoff, gebildet. Dabei sind Kompositbeschichtungen umfassend Schichtfolgen aus abwechselnd Titannitrid / Niobnitrid oder Titannitrid / Karbonitrid als bevorzugt genannt.

Die JP 2016 183382 A offenbart eine Beschichtung auf einem Kolbenring umfassend die Schichtfolge Chrom, Chromnitrid, Kupfer, wobei sich Chromnitrid und Kupfer abwechselnd mehrmals wiederholen.

Die WO 2015 / 186 790 A1 beschreibt eine Beschichtung auf einem Kolbenring umfassend die Schichtfolge Chrom, Titan-Chromnitrid, Kupfer, wobei sich Titan-Chromnitrid und Kupfer abwechselnd mehrmals wiederholen.

Es hat sich gezeigt, dass die im Stand der Technik beschriebenen Kompositschichten, umfassend eine Metallmatrix und darin eingebettete Körner eines nitridischen Hartstoffs, zwar eine Verschleißschutzschicht ausbilden, dass allerdings eine ausreichende Reduzierung der Reibung gegenüber einem Reibpartner, insbesondere unter Verwendung von Schmiermitteln im Bereich einer Kontaktfläche zwischen dem Schichtsystem und dem Reibpartner, nicht erreicht wird. Während diamantartige Schichten, auch DLC-Schichten genannt, sowohl eine Verschleißschutzschicht ausbilden als auch bei Einsatz von Schmiermitteln für eine effiziente Reibungsreduzierung gegenüber einem Reibpartner sorgen, ist dies bei den beschriebenen Kompositschichten umfassend eine Metallmatrix und darin eingebettete Körner eines nitridischen Hartstoffs nicht in der gleichen Weise beobachtbar.

Es ist Aufgabe der Erfindung, ein Schichtsystem enthaltend mindestens einen nitridischen Hartstoff bereitzustellen, das sowohl als Verschleißschutzschicht dient und bei einem reibenden Verschleiß unter Schmiermitteleinsatz eine Reibungsreduzierung gegenüber dem Reibpartner bewirkt. Weiterhin ist es Aufgabe der Erfindung, ein Bauteil bereitzustellen, das zumindest partiell mit einem derartigen Schichtsystem beschichtet ist.

Die Aufgabe wird durch ein Schichtsystem gelöst umfassend:
- mindestens eine Haftvermittlerschicht; und
- mehrere, auf der mindestens einen Haftvermittlerschicht angeordnete Funktionsschichten, wobei jede Funktionsschicht eine erste Nanolage aus einem ersten Metallnitrid umfassend eine erste Metallkomponente sowie eine metallische zweite Nanolage (3b, 4b, 5b, 6b) umfasst, wobei jede Funktionsschicht (3, 4, 5, 6) eine Schichtdicke d im Bereich von 1 bis 100 nm aufweist, wobei die metallische zweite Nanolage gebildet ist aus mindestens einem Metall aus der Gruppe umfassend Kupfer, Palladium, Silber, Platin, Iridium, Gold, und wobei das erste Metallnitrid der ersten Nanolage (3a, 4a, 5a, 6a) durch Molybdännitrid MoN gebildet ist.

Unter einer "Nanolage" wird im Sinne der Erfindung eine Einzelschicht verstanden, die eine Schichtdicke im Bereich von 0,1 bis 99,9 nm aufweist. Dabei bilden zwei Nanolagen zusammen eine Funktionsschicht mit der Schichtdicke d aus. Insbesondere liegt eine Schichtdicke einer Nanolage im Bereich von 1 bis 20 nm.

Es hat sich überraschender Weise gezeigt, dass das erfindungsgemäße Schichtsystem eine hohe Verschleißschutzwirkung bereitstellt und weiterhin einem Reibpartner gegenüber unter Einsatz von Schmiermitteln zu einer effektiveren Reduzierung der Reibung führt, als wenn eine eingangs genanntes Kompositschicht zum Einsatz kommt.

Unter einem Schmiermittel werden hier Schmieröl, Schmierfett, Wachse, Festschmierstoffe, und dergleichen, sowie deren Kombinationen, sowie auch Schmieröle enthaltend herkömmliche Motorenadditive, verstanden. Insbesondere ist eine zweite Nanolage gebildet aus Kupfer bevorzugt.

Bevorzugt umfasst die mindestens eine Haftvermittlerschicht eine erste Haftvermittlerschicht aus einem weiteren Metall oder einem zweiten Metallnitrid umfassend eine zweite Metallkomponente. Dabei kann das weitere Metall oder die zweite Metallkomponente gleich oder unterschiedlich zur ersten Metallkomponente des ersten Metallnitrids der ersten Nanolagen gewählt sein. Insbesondere ist die erste Haftvermittlerschicht aus Chrom, Chrom-Aluminium-Legierungen, Titan, Molybdän oder Zirkon gebildet. Alternativ hat es sich bewährt, wenn die erste Haftvermittlerschicht aus einem Chromnitrid CrN, Titannitrid TiN, CrAlN oder Molybdännitrid MoN gebildet ist.

Die erste Haftvermittlerschicht weist eine bevorzugte Schichtdicke im Bereich von 0,01 bis 2 µm auf.

Weiterhin ist bevorzugt, wenn die mindestens eine Haftvermittlerschicht eine zweite Haftvermittlerschicht umfasst, wobei diese die erste Metallkomponente des in der Funktionsschicht vorgesehenen ersten Metallnitrids und weiterhin das in der ersten Haftvermittlerschicht enthaltene weitere Metall oder die zweite Metallkomponente umfasst. Die zweite Haftvermittlerschicht weist dabei insbesondere einen Gradientenverlauf auf, wobei der Anteil des weiteren Metalls oder der zweiten Metallkomponente, das/die in der ersten Haftvermittlerschicht enthalten ist, in Richtung der Mehrzahl von Funktionsschichten abnimmt und der Anteil der ersten Metallkomponente des in der Funktionsschicht vorgesehenen ersten Metallnitrids entsprechend zunimmt. Die zweite Haftvermittlerschicht stellt damit einen Übergang zwischen der ersten Haftvermittlerschicht und der an die zweite Haftvermittlerschicht angrenzenden Funktionsschicht her.

Die zweite Haftvermittlerschicht weist eine bevorzugte Schichtdicke im Bereich von 0,01 bis 2 µm auf.

Dabei ist bevorzugt, dass nacheinander die erste Haftvermittlerschicht, auf der ersten Haftvermittlerschicht die zweite Haftvermittlerschicht und auf der zweiten Haftvermittlerschicht die mehreren Funktionsschichten angeordnet sind.

Insbesondere ist eine Anzahl n an Funktionsschichten im Bereich von 10 bis 10000, besonders bevorzugt im Bereich von 100 bis 1000, vorhanden.

In einer besonders bevorzugten Ausführungsform der Erfindung weist das Schichtsystem, umfassend die mindestens eine Haftvermittlerschicht und die mehreren Funktionsschichten, eine Gesamtschichtdicke D im Bereich von 0,1 µm bis 10 µm auf. Bei einer derartigen Gesamtschichtdicke ist einerseits eine ausgezeichnete Haftung des Schichtsystems an einem Substrat bei gleichzeitig geringer Herstelldauer und geringen Prozesskosten erzielbar, sowie andererseits ein effizienter Verschleißschutz und eine Reibungsreduzierung bei Verwendung von Schmiermitteln.

Es hat sich bewährt, wenn die erste Nanolage einer jeden Funktionsschicht dicker ausgebildet ist als die der Funktionsschicht zugehörige zweite Nanolage. Dadurch lassen sich die reibmindernden Eigenschaften des Schichtsystems optimieren.

Eine Summe der Funktionsschichten des Schichtsystems weist vorzugsweise einen mittleren Gehalt an Metall der zweiten Nanolage im Bereich von 0,1 bis 20 At.-% auf.

Das erfindungsgemäße Schichtsystem ist/wird bevorzugt mittels eines PVD-Verfahrens (PVD = Physical Vapour Deposition) bei Temperaturen kleiner als 350°C ausgebildet.

Das Schichtsystem weist insbesondere eine Vickers-Härte im Bereich von 1000 bis 4000 HV auf. Dadurch ist ein hoher Verschleißschutz gewährleistet.

Die Aufgabe wird weiterhin gelöst durch ein Bauteil, umfassend ein metallisches Substrat und ein zumindest partiell auf einer Oberfläche des Substrats angeordnetes erfindungsgemäßes Schichtsystem, wobei die mindestens eine Haftvermittlerschicht, insbesondere die erste Haftvermittlerschicht, angrenzend an das Substrat angeordnet ist.

Das metallische Substrat ist bevorzugt aus Stahl gebildet. Insbesondere sind dabei Stahlsorten wie 16MnCr5, C45, 100Cr6, 31CrMoV9, 80Cr2, 42CrMo4 und dergleichen bevorzugt.

Das Bauteil ist insbesondere als ein Maschinenbauteil, insbesondere in Form eines Tassenstößels, einer Kettenkomponente, einer Wälzlagerkomponente, eines Steuerkolbens, einer Lagerbuchse, eines Schlepphebels, einer Rollenstößelkomponente, einer Gleitlagerkomponente und dergleichen ausgebildet.

Zur Ausbildung des Schichtsystems in einem PVD-Verfahren (PVD = Physical Vapour Deposition) wird bevorzugt eine Apparatur zur Kathodenzerstäubung eingesetzt.

In einem ersten Schritt wird die mindestens eine Haftvermittlerschicht zumindest partiell auf mindestens ein Substrat aufgebracht. Insbesondere wird eine metallische erste Haftvermittlerschicht, beispielsweise aus Chrom, auf der Oberfläche des mindestens einen Substrats abgeschieden. Dabei kann eine vollflächige oder partielle Abscheidung der ersten Haftvermittlerschicht auf dem Substrat erfolgen.

Anschließend wird eine zweite Haftvermittlerschicht, insbesondere aus Chrom und Molybdän, auf der ersten Haftvermittlerschicht abgeschieden. Dabei nimmt der Gehalt an Chrom ausgehend von der ersten Haftvermittlerschicht in Richtung der Funktionsschicht bevorzugt ab.

Zur Ausbildung der Funktionsschichten werden die Substrate beispielsweise auf einem Substrathalter angeordnet, der in einer Vakuumkammer der Apparatur zur Kathodenzerstäubung mittig um eine senkrechte Achse rotierbar ist. An sich gegenüberliegenden Seitenwänden der Vakuumkammer werden Targets angeordnet, die aus unterschiedlichen Zerstäubungsmaterialien gebildet sind. Hier wird die Vorgehensweise anhand von Funktionsschichten umfassend jeweils eine erste Nanolage aus Molybdännitrid MoN und eine zweite Nanolage aus Kupfer beispielhaft beschrieben. An einer ersten Seitenwand der Vakuumkammer wird mindestens ein Kupfertarget und auf der gegenüberliegenden Seitenwand mindestens ein Molybdäntarget angeordnet. Ein oder mehrere Substrate werden derart an dem Substrathalter und in der Vakuumkammer um die senkrechte Achse rotierbar angeordnet, dass ein jedes abwechselnd in den Einflussbereich des mindestens einen Kupfertargets und den des mindestens einen Molybdäntargets gelangt. In die Vakuumkammer wird als Reaktionsgas Stickstoff eingebracht, welches im Bereich des mindestens einen Molybdäntargets mit dem zerstäubten Molybdän, welches ein Nitridbildner ist, reagiert und auf dem Substrat als erste Nanolage aus Molybdännitrid MoN abgeschieden wird. Das Substrat wird durch den Substrathalter nun in Richtung des mindestens einen Kupfertargets rotiert und auf der gebildeten ersten Nanolage aus MoN eine zweite Nanolage aus Kupfer Cu abgeschieden, wodurch eine erste Funktionsschicht fertiggestellt ist. Um weitere Funktionsschichten aufzubringen, wird das Substrat durch den Substrathalter nun weiter in Richtung des mindestens einen Molybdäntargets rotiert und auf der gebildeten zweiten Nanolage aus Kupfer eine weitere erste Nanolage aus MoN gebildet. Das Substrat wird durch den Substrathalter erneut in Richtung des mindestens einen Kupfertargets rotiert und auf der gebildeten weiteren ersten Nanolage aus MoN eine weitere zweite Nanolage aus Kupfer abgeschieden, wodurch eine zweite Funktionsschicht fertiggestellt ist. Es werden nun so viele weitere Funktionsschichten in gleicher Art aufgebracht, bis vorzugsweise eine Gesamtschichtdicke D des Schichtsystems im Bereich von 0,1 bis 10 µm erreicht ist. Dabei wirkt sich die Drehgeschwindigkeit des Substrathalters unmittelbar auf die Schichtdicke und die Anzahl der Nanolagen aus. Je höher die Drehgeschwindigkeit bei ansonsten gleichbleibenden Abscheidebedingungen gewählt ist, desto geringer ist die Schichtdicke einer Nanolage und desto höher ist die Anzahl n an Nanolagen im Schichtsystem.

Es können aber auch Durchlaufanlagen zur Kathodenzerstäubung eingesetzt werden, um das Schichtsystem herzustellen, bei welcher die Substrate in einer Durchschubrichtung durch eine Vakuumkammer transportiert werden. Dabei können die Substrate zusätzlich zu einer Bewegung in Durchschubrichtung weiterhin um ihre Längsachse gedreht oder gewendet werden.

Nachfolgend wird ein besonders bevorzugtes erfindungsgemäßes Schichtsysteme beschrieben:

### Schichtsystem 1:

| | |
|---|---|
| Erste Haftvermittlerschicht: | Chrom |
| Zweite Haftvermittlerschicht: | Chrom, Molybdän |
| Funktionsschicht: | erste Nanolage: MoN |
| | zweite Nanolage: Cu |

Die Funktionsschicht ist dabei mindestens 10 Mal vorhanden.

Nachfolgend werden weitere, nicht-erfindungsgemäße Schichtsysteme beschrieben:

### Schichtsystem 2:

| | |
|---|---|
| Erste Haftvermittlerschicht: | Chrom |
| Zweite Haftvermittlerschicht: | Chrom, Niob |
| Funktionsschicht: | erste Nanolage: NbN |
| | zweite Nanolage: Cu |

Die Funktionsschicht ist dabei mindestens 10 Mal vorhanden.

### Schichtsystem 3:

| | |
|---|---|
| Erste Haftvermittlerschicht: | Chrom |
| Zweite Haftvermittlerschicht: | Chrom, Titan |
| Funktionsschicht: | erste Nanolage: TiN |
| | zweite Nanolage: Cu |

Die Funktionsschicht ist dabei mindestens 10 Mal vorhanden.

### Schichtsystem 4:

| | |
|---|---|
| Erste Haftvermittlerschicht: | Chrom |
| Zweite Haftvermittlerschicht: | Chrom, Tantal |
| Funktionsschicht: | erste Nanolage: TaN |
| | zweite Nanolage: Cu |

Die Funktionsschicht ist dabei mindestens 10 Mal vorhanden.

### Schichtsystem 5:

| | |
|---|---|
| Erste Haftvermittlerschicht: | Chrom |
| Zweite Haftvermittlerschicht: | Chrom, Zirkon |
| Funktionsschicht: | erste Nanolage: ZrN |
| | zweite Nanolage: Cu |

Die Funktionsschicht ist dabei mindestens 10 Mal vorhanden.

### Schichtsystem 6:

| | |
|---|---|
| Erste Haftvermittlerschicht: | Chromnitrid |
| Zweite Haftvermittlerschicht: | Chrom, Zirkon |
| Funktionsschicht: | erste Nanolage: ZrN |
| | zweite Nanolage: Pd |

Die Funktionsschicht ist dabei mindestens 10 Mal vorhanden.

Nachfolgend werden weitere besonders bevorzugte erfindungsgemäße Schichtsysteme beschrieben:

### Schichtsystem 7:

| | |
|---|---|
| Erste Haftvermittlerschicht: | Chromnitrid |
| Zweite Haftvermittlerschicht: | Chrom, Molybdän |
| Funktionsschicht: | erste Nanolage: MoN |
| | zweite Nanolage: Ag |

Die Funktionsschicht ist dabei mindestens 100 Mal vorhanden.

### Schichtsystem 8:

| | |
|---|---|
| Erste Haftvermittlerschicht: | Titan |
| Zweite Haftvermittlerschicht: | Titan, Molybdän |
| Funktionsschicht: | erste Nanolage: MoN |
| | zweite Nanolage: Au |

Die Funktionsschicht ist dabei mindestens 100 Mal vorhanden.

### Schichtsystem 9:

| | |
|---|---|
| Haftvermittlerschicht: | Molybdän |
| Funktionsschicht: | erste Nanolage: MoN |
| | zweite Nanolage: Cu |

Die Funktionsschicht ist dabei mindestens 10 Mal vorhanden.

### Schichtsystem 10:

| | |
|---|---|
| Erste Haftvermittlerschicht: | Titannitrid |
| Zweite Haftvermittlerschicht: | Titan, Molybdän |
| Funktionsschicht: | erste Nanolage: MoN |
| | zweite Nanolage: Ir |

Die Funktionsschicht ist dabei mindestens 10 Mal vorhanden.

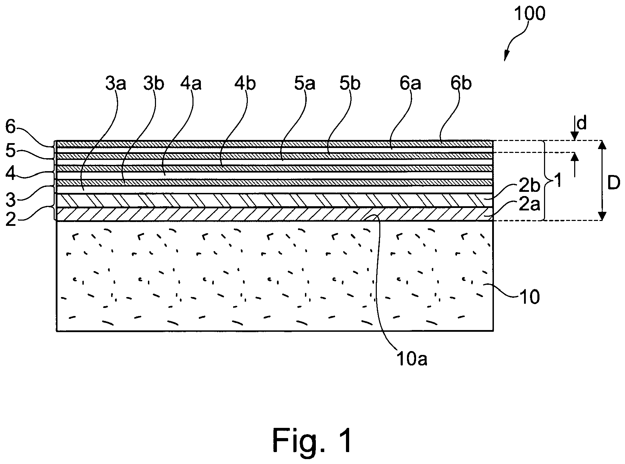

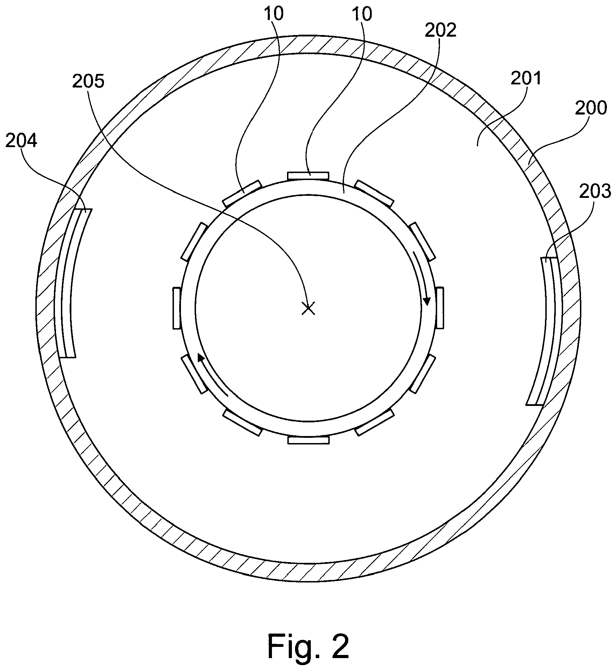

Das erfindungsgemäße Schichtsystem und ein Bauteil in Form eines damit zumindest partiell beschichteten Substrats soll mittels der Figuren 1 und 2 beispielhaft erläutert werden.

So zeigt:
- Figur 1: ein Bauteil mit einem Schichtsystem; und
- Figur 2: eine Apparatur zur Bildung des ersten Schichtsystems auf einem Substrat im Querschnitt in der Draufsicht.

Figur 1 zeigt ein Bauteil 100 mit einem Schichtsystem 1, das auf einen Teil einer Oberfläche 10a eines Substrats 10 aufgebracht ist. Das Substrat 10 ist hier aus Stahl gebildet. Das Schichtsystem 1 umfasst ausgehend von der Oberfläche 10a des Substrats 10 eine Haftvermittlerschicht 2, welche eine erste Haftvermittlerschicht 2a aus Chrom und eine zweite Haftvermittlerschicht 2b aus Chrom und Molybdän umfasst. Der Gehalt an Chrom der zweiten Haftvermittlerschicht 2b folgt einem Gradienten und sinkt ausgehend von der ersten Haftvermittlerschicht 2a in Richtung der Funktionsschichten 3, 4, 5, 6. Es sind hier der Übersichtlichkeit halber lediglich vier der vorgesehenen Anzahl an n = 15 Funktionsschichten dargestellt. Auf der zweiten Haftvermittlerschicht 2b ist eine erste Funktionsschicht 3 aufgebracht, welche eine erste Nanolage 3a aus Molybdännitrid MoN und darauf eine zweite Nanolage 3b aus Kupfer Cu umfasst. Auf der ersten Funktionsschicht 3 ist eine zweite Funktionsschicht 4 aufgebracht, welche ebenfalls eine erste Nanolage 4a aus MoN und darauf eine zweite Nanolage 4b aus Cu umfasst. Auf der zweiten Funktionsschicht 4 ist eine dritte Funktionsschicht 5 aufgebracht, welche ebenfalls eine erste Nanolage 5a aus MoN und darauf eine zweite Nanolage 5b aus Cu umfasst. Auf der dritten Funktionsschicht 5 ist eine vierte Funktionsschicht 6 aufgebracht, welche ebenfalls eine erste Nanolage 6a aus MoN und darauf eine zweite Nanolage 6b aus Cu umfasst. Die Gesamtschichtdicke D des Schichtsystems 1 beträgt hier 0,5 µm. Die Schichtdicke einer jeden Funktionsschicht 3, 4, 5, 6 beträgt hier 15 nm, wobei eine jede erste Nanolage 3a, 4a, 5a, 6a eine Schichtdicke von ca. 10 nm und jede zweite Nanolage 3b, 4b, 5b, 6b eine Schichtdicke von etwa 5 nm aufweist.

Figur 2 zeigt lediglich beispielhaft und schematisch eine Apparatur zur Bildung des Schichtsystems 1 gemäß Figur 1 auf dem Substrat 10 im Querschnitt und in der Draufsicht. Die Apparatur ist lediglich schematisch dargestellt und umfasst eine Vakuumbehälter 200 mit einer Vakuumkammer 201, in welcher ein Substrathalter 202 angeordnet ist. Der Substrathalter 202 ist in Form eines, um eine senkrechte Achse 205 rotierbaren Hohlzylinders (siehe Pfeile zur Kennzeichnung der Drehrichtung in Figur 2) ausgebildet, an dessen Außenseite eine Mehrzahl an Substraten 10 befestigt ist. An sich in der Vakuumkammer 201 gegenüberliegenden Seitenwänden des Vakuumbehälters 200 sind Targets 203, 204 angeordnet. Das Target 203 ist mindestens ein Molybdäntarget zur Zerstäubung von Molybdän und Ausbildung der ersten Nanolagen 3a, 4a, 5a, 6a (vergleiche Figur 1), während das weitere Target 204 mindestens ein Kupfertarget zur Zerstäubung von Kupfer und Ausbildung der zweiten Nanolagen 3b, 4b, 5b, 6b ist. In der Vakuumkammer 201 ist ein Unterdruck eingestellt, wobei eine Atmosphäre enthaltend Stickstoff als Reaktionsgas vorliegt. Bei der Kathodenzerstäubung wird das Molybdän des Targets 203 zerstäubt und reagiert mit dem Stickstoff in der Vakuumkammer 201. Auf den Substraten 10, die sich bei Rotation des Substrathalters 202 jeweils zwischen dem Target 203 und dem Substrathalter 202 befinden, wird eine erste Nanolage 3a, 4a, 5a, 6a aus MoN abgeschieden. Aufgrund der Rotation des Substrathalters 202 werden die mit der ersten Nanolage 3a, 4a, 5a, 6a beschichteten Substrate 10 daraufhin in Richtung des Targets 204 transportiert, bis diese sich zwischen dem Target 204 und dem Substrathalter 202 befinden. Nun wird auf der ersten Nanolage 3a, 4a, 5a, 6a die zweite Nanolage 3b, 4b, 5b, 6b gebildet. Durch Weiterdrehen des Substrathalters 202 erfolgt ein weiterer Auftrag von weiteren Funktionsschichten, bis die gewünschte Anzahl n an Funktionsschichten erreicht ist.

### Bezugszeichenliste:

- 1: Schichtsystem
- 2: Haftvermittlerschicht
- 2a: erste Haftvermittlerschicht
- 2b: zweite Haftvermittlerschicht
- 3, 4, 5, 6: Funktionsschicht
- 3a, 4a, 5a, 6a: erste Nanolage
- 3b, 4b, 5b, 6b: zweite Nanolage
- 10: Substrat
- 10a: Oberfläche des Substrats
- 100: Bauteil
- 200: Vakuumbehälter
- 201: Vakuumkammer
- 202: Substrathalter
- 203: Target
- 204: Target
- 205: senkrechte Achse
- n: Anzahl an Funktionsschichten
- d: Schichtdicke einer Funktionsschicht
- D: Gesamtschichtdicke des Schichtsystems

## Patentansprüche

1. Schichtsystem (1), umfassend
- mindestens eine Haftvermittlerschicht (2a, 2b); und
- mehrere, auf der mindestens einen Haftvermittlerschicht (2a, 2b) angeordnete Funktionsschichten (3, 4, 5, 6), wobei jede Funktionsschicht (3, 4, 5, 6) eine erste Nanolage (3a, 4a, 5a, 6a) aus einem ersten Metallnitrid umfassend eine erste Metallkomponente sowie eine metallische zweite Nanolage (3b, 4b, 5b, 6b) umfasst, wobei jede Funktionsschicht (3, 4, 5, 6) eine Schichtdicke d im Bereich von 1 bis 100 nm aufweist, wobei die metallische zweite Nanolage (3b, 4b, 5b, 6b) gebildet ist aus mindestens einem Metall aus der Gruppe umfassend Kupfer, Palladium, Silber, Platin, Iridium, Gold, **dadurch gekennzeichnet, dass** das erste Metallnitrid der ersten Nanolage (3a, 4a, 5a, 6a) durch Molybdännitrid MoN gebildet ist.

2. Schichtsystem (1) nach Anspruch 1, wobei die mindestens eine Haftvermittlerschicht (2a, 2b) eine erste Haftvermittlerschicht (2a) aus einem weiteren Metall oder aus einem zweiten Metallnitrid umfassend eine zweite Metallkomponente umfasst.

3. Schichtsystem (1) nach einem der Ansprüche 1 oder 2, wobei die mindestens eine Haftvermittlerschicht (2a, 2b) eine zweite Haftvermittlerschicht (2b) umfassend die erste Metallkomponente sowie weiterhin entweder ein/das weitere(s) Metall oder eine/die zweite Metallkomponente umfasst.

4. Schichtsystem (1) nach Anspruch 3, wobei nacheinander die erste Haftvermittlerschicht (2a), auf der ersten Haftvermittlerschicht (2a) die zweite Haftvermittlerschicht (2b) und auf der zweiten Haftvermittlerschicht (2b) die mehreren Funktionsschichten (3, 4, 5, 6) angeordnet sind.

5. Schichtsystem (1) nach einem der Ansprüche 1 bis 4, wobei eine Anzahl n an Funktionsschichten (3, 4, 5, 6) vorhanden ist und n im Bereich von 10 bis 10000 gewählt ist.

6. Schichtsystem (1) nach einem der Ansprüche 1 bis 5, wobei das Schichtsystem (1) eine Gesamtschichtdicke D im Bereich von 0,1 µm bis 10 µm aufweist.

7. Schichtsystem (1) nach einem der Ansprüche 1 bis 6, wobei die erste Nanolage (3a, 4a, 5a, 6a) einer jeden Funktionsschicht (3, 4, 5, 6) dicker ausgebildet ist als die der Funktionsschicht zugehörige zweite Nanolage (3b, 4b, 5b, 6b).

8. Schichtsystem (1) nach einem der Ansprüche 1 bis 7, wobei jede Funktionsschicht (3, 4, 5, 6) eine zweite Nanolage (3b, 4b, 5b, 6b) aus Kupfer aufweist.

9. Schichtsystem (1) nach Anspruch 8, wobei eine Summe der Funktionsschichten (3, 4, 5, 6) einen mittleren Gehalt an Metall der zweiten Nanolage (3b, 4b, 5b, 6b) im Bereich von 0,1 bis 20 At.-% aufweist.

10. Schichtsystem (1) nach einem der Ansprüche 1 bis 9, wobei das Schichtsystem (1) eine Vickers-Härte im Bereich von 1000 bis 4000 HV aufweist

11. Bauteil (100), umfassend ein metallisches Substrat (10) und ein zumindest partiell auf einer Oberfläche des Substrats (10) angeordnetes Schichtsystem (1) nach einem der Ansprüche 1 bis 10, wobei die mindestens eine Haftvermittlerschicht (2a, 2b) angrenzend an das Substrat (10) angeordnet ist.

12. Bauteil nach Anspruch 11, wobei das Substrat (10) aus Stahl gebildet ist.

13. Bauteil nach Anspruch 11 oder Anspruch 12, wobei das Bauteil als ein Maschinenbauteil, insbesondere in Form eines Tassenstößels, einer Kettenkomponente, einer Wälzlagerkomponente, eines Steuerkolbens, einer Lagerbuchse, eines Schlepphebels, einer Rollenstößelkomponente oder einer Gleitlagerkomponente, ausbildet ist.

## Claims

1. A layer system (1) comprising
- at least one adhesion promoter layer (2a, 2b); and
- a plurality of functional layers (3, 4, 5, 6) arranged on the at least one adhesion promoter layer (2a, 2b), wherein each functional layer (3, 4, 5, 6) comprises a first nanolayer (3a, 4a, 5a, 6a) made of a first metal nitride comprising a first metal component and a metallic second nanolayer (3b, 4b, 5b, 6b), wherein each functional layer (3, 4, 5, 6) has a layer thickness d in the range from 1 to 100 nm, wherein the metallic second nanolayer (3b, 4b, 5b, 6b) is formed from at least one metal from the group comprising copper, palladium, silver, platinum, iridium and gold, **characterised in that** the first metal nitride of the first nanolayer (3a, 4a, 5a, 6a) is formed by molybdenum nitride MoN.

2. The layer system (1) according to claim 1, wherein the at least one adhesion promoter layer (2a, 2b) comprises a first adhesion promoter layer (2a) made of a further metal or of a second metal nitride comprising a second metal component.

3. The layer system (1) according to any one of claims 1 or 2, wherein the at least one adhesion promoter layer (2a, 2b) comprises a second adhesion promoter layer (2b) comprising the first metal component and also either a/the further metal or a/the second metal component.

4. The layer system (1) according to claim 3, wherein there is a successive arrangement of the first adhesion promoter layer (2a), the second adhesion promoter layer (2b) on the first adhesion promoter layer (2a), and the plurality of functional layers (3, 4, 5, 6) on the second adhesion promoter layer (2b).

5. The layer system (1) according to any one of claims 1 to 4, wherein a number n of functional layers (3, 4, 5, 6) is present and n is selected in the range from 10 to 10,000.

6. The layer system (1) according to any one of claims 1 to 5, wherein the layer system (1) has a total layer thickness D in the range from 0.1 µm to 10 µm.

7. The layer system (1) according to any one of claims 1 to 6, wherein the first nanolayer (3a, 4a, 5a, 6a) of each functional layer (3, 4, 5, 6) is thicker than the second nanolayer (3b, 4b, 5b, 6b) associated with the functional layer.

8. The layer system (1) according to any one of claims 1 to 7, wherein each functional layer (3, 4, 5, 6) has a second nanolayer (3b, 4b, 5b, 6b) made of copper.

9. The layer system (1) according to claim 8, wherein a sum of the functional layers (3, 4, 5, 6) has an average content of metal of the second nanolayer (3b, 4b, 5b, 6b) in the range of 0.1 to 20 at%.

10. The layer system (1) according to any one of claims 1 to 9, wherein the layer system (1) has a Vickers hardness in the range from 1000 to 4000 HV.

11. A component (100), comprising a metallic substrate (10) and a layer system (1) according to any one of claims 1 to 10 which is arranged at least partially on a surface of the substrate (10), wherein the at least one adhesion promoter layer (2a, 2b) is arranged adjacent to the substrate (10).

12. The component according to claim 11, wherein the substrate (10) is formed of steel.

13. The component according to claim 11 or claim 12, wherein the component is formed as a machine component, in particular in the form of a bucket tappet, a chain component, a rolling bearing component, a control piston, a bearing bush, a rocker arm, a roller tappet component or a plain bearing component.

## Revendications

1. Système stratifié (1), comprenant
- au moins une couche d'agent d'accrochage (2a, 2b) ; et
- plusieurs couches fonctionnelles (3, 4, 5, 6) disposées sur l'au moins une couche d'agent d'accrochage (2a, 2b), chaque couche fonctionnelle (3, 4, 5, 6) comprenant une première nanostrate (3a, 4a, 5a, 6a) constituée d'un premier nitrure métallique comprenant un premier constituant métallique ainsi qu'une seconde nanostrate métallique (3b, 4b, 5b, 6b), chaque couche fonctionnelle (3, 4, 5, 6) présentant une épaisseur de couche d dans la plage allant de 1 à 100 nm, la seconde nanostrate métallique (3b, 4b, 5b, 6b) étant formée d'au moins un métal du groupe constitué par le cuivre, le palladium, l'argent, le platine, l'iridium, l'or, **caractérisé en ce que** le premier nitrure métallique de la première nanostrate (3a, 4a, 5a, 6a) est constitué de nitrure de molybdène MoN.

2. Système stratifié (1) selon la revendication 1, dans lequel l'au moins une couche d'agent d'accrochage (2a, 2b) comprend une première couche d'agent d'accrochage (2a) constituée d'un autre métal ou d'un second nitrure métallique comprenant un second constituant métallique.

3. Système stratifié (1) selon l'une quelconque des revendications 1 ou 2, dans lequel l'au moins une couche d'agent d'accrochage (2a, 2b) comprend une seconde couche d'agent d'accrochage (2b) comprenant le premier constituant métallique ainsi que soit un/l'autre métal soit un/le second constituant métallique.

4. Système stratifié (1) selon la revendication 3, dans lequel sont disposées successivement la première couche d'agent d'accrochage (2a), la seconde couche d'agent d'accrochage (2b) sur la première couche d'agent d'accrochage (2a) et, sur la deuxième couche d'agent d'accrochage (2b), les plusieurs couches fonctionnelles (3, 4, 5, 6).

5. Système stratifié (1) selon l'une quelconque des revendications 1 à 4, dans lequel un nombre n de couches fonctionnelles (3, 4, 5, 6) est présent et n est sélectionné dans la plage allant de 10 à10 000.

6. Système stratifié (1) selon l'une quelconque des revendications 1 à 5, dans lequel le système stratifié (1) présente une épaisseur totale de couche D dans la plage allant de 0,1 µm à 10 µm.

7. Système stratifié (1) selon l'une quelconque des revendications 1 à 6, dans lequel la première nanostrate (3a, 4a, 5a, 6a) de chaque couche fonctionnelle (3, 4, 5, 6) est conçue de manière plus épaisse que la seconde nanostrate (3b, 4b, 5b, 6b) associée à la couche fonctionnelle.

8. Système stratifié (1) selon l'une quelconque des revendications 1 à 7, dans lequel chaque couche fonctionnelle (3, 4, 5, 6) présente une seconde nanostrate (3b, 4b, 5b, 6b) en cuivre.

9. Système stratifié (1) selon la revendication 8, dans lequel une somme des couches fonctionnelles (3, 4, 5, 6) présente une teneur moyenne en métal de la seconde nanostrate (3b, 4b, 5b, 6b) dans la plage allant de 0,1 bis 20 % at.

10. Système stratifié (1) selon l'une quelconque des revendications 1 à 9, dans lequel le système stratifié (1) présente une dureté Vickers dans la plage allant de 1 000 à 4 000 HV.

11. Composant (100), comprenant un substrat métallique (10) et un système stratifié (1) selon l'une quelconque des revendications 1 à 10 disposé au moins partiellement sur une surface du substrat (10), dans lequel l'au moins une couche d'agent d'accrochage (2a, 2b) est disposée de manière adjacente au substrat (10).

12. Composant selon la revendication 11, dans lequel le substrat (10) est constitué d'acier.

13. Composant selon la revendication 11 ou la revendication 12, le composant étant conçu sous la forme d'un composant de machine, en particulier sous la forme d'un poussoir à coupelle, d'un constituant de chaîne, d'un constituant de palier à roulements, d'un piston de commande, d'un coussinet, d'un culbuteur, d'un constituant de poussoir de soupape à galet ou d'un constituant de palier lisse.
